Europäisches Patentamt

European Patent Office

Office européen des brevets

(19)

(11) Veröffentlichungsnummer : **0 197 376**
**B1**

(12) **EUROPÄISCHE PATENTSCHRIFT**

(45) Veröffentlichungstag der Patentschrift :
02.11.89

(51) Int. Cl.⁴ : **H 05 K   7/10**, H 01 R 23/68

(21) Anmeldenummer : 86103702.6

(22) Anmeldetag : 19.03.86

(54) **Sockel für Bauelement.**

(30) Priorität : 11.04.85 DE 3513028

(43) Veröffentlichungstag der Anmeldung :
15.10.86 Patentblatt 86/42

(45) Bekanntmachung des Hinweises auf die Patenterteilung : 02.11.89 Patentblatt 89/44

(84) Benannte Vertragsstaaten :
DE FR GB IT SE

(56) Entgegenhaltungen :
WO--A--80 /005 13
US--A-- 4 266 840
US--A-- 4 533 192

(73) Patentinhaber : **Nixdorf Computer Aktiengesellschaft**
**Fürstenallee 7**
**D-4790 Paderborn (DE)**

(72) Erfinder : **Haftmann, Johannes**
**Igelsdorfer Weg 14**
**D-8540 Schwabach (DE)**

(74) Vertreter : **Schaumburg, Thoenes & Englaender**
**Mauerkircherstrasse 31 Postfach 86 07 48**
**D-8000 München 80 (DE)**

Jouve, 18, rue St-Denis, 75001 Paris, France

## Beschreibung

Die Erfindung betrifft einen Sockel zur Halterung eines eine Vielzahl von Anschlußstiften aufweisenden elektronischen Bauelementes auf einer Leiterplatte, umfassend eine Sockelplatte mit einer Vielzahl von Einstecköffnungen, in denen jeweils eine Kontaktfeder zum Kontaktieren eines in die Einstecköffnung eingeführten Anschlußstiftes des Bauelementes angeordnet ist wobei ein Auflagekörper für das Bauelement auf der Sockelplatte angeordnet ist, der parallel zur Einsteckrichtung der Anschlußstifte relativ zur Sockelplatte aus einer sockelplattenfernen ersten Stellung gegen Federkraft in eine Sockelplattennahe, dem vollständigen Einführen der Anschlußstifte in die Einstecköffnungen entsprechende zweite Stellung verstellbar ist, wobei der Auflagekörper jeweils durch Tastdruck in Richtung auf die Sockelplatte in seiner zweiten Stellung verriegelbar ist, siehe z. B. US-A-4 266 840.

Kompliziertere elektronische Bauelemente mit einer Vielzahl von Anschlußstiften wie beispielsweise integrierte Schaltungen werden in der Regel nicht direkt auf Leiterplatten aufgelötet sondern mit Hilfe von Sockeln oder Fassungen, die ihrerseits auf der Leiterplatte aufgelötet sind, an dieser befestigt. Dies gilt insbesondere für größere Leiterplatten, die eine Mehrzahl derartiger häufig recht kostspieliger Bauelemente enthalten und bei denen es im Falle eines Fehlers zu teuer wäre, einfach die ganze Leiterplatte auszutauschen. Sind die Bauelemente dagegen mit Hilfe eines Sockels an der Leiterplatte befestigt, besteht die Möglichkeit, die Bauelemente bei der Fehlersuche einzeln herauszunehmen und zu überprüfen und gegebenenfalls auszutauschen.

Einfache Stecksockel für die Bauelemente besitzen im allgemeinen eine der Größe der Bauelemente entsprechende Grundfläche, so daß sich die Bauelemente mit diesen Sockeln sehr dicht auf einer Leiterplatte nebeneinander anordnen lassen. Nachteilig an diesen Sockeln ist im allgemeinen, daß sowohl das Einstecken als auch das Herausziehen der Bauelemente in den bzw. aus dem Sockel eine gewisse Kraft erfordert, da die Kontaktfedern zur Sicherstellung eines guten elektrischen Kontaktes mit den Anschlußstiften eine gewisse Klemmkraft besitzen. Dabei besteht die Gefahr, daß die sehr dünnen Anschlußstifte oder Beinchen an den Bauelementen sich verbiegen oder gar abknicken. Ein abgebrochener Anschlußstift macht das gesamte Bauelement wertlos. Die Gefahr einer Beschädigung der Anschlußstifte ist besonders beim Herausziehen der Bauelemente aus dem Sockel groß, da wegen der dichten Packung der Bauelemente auf einer Leiterplatte keine Möglichkeit besteht, Werkzeuge von beiden Seiten her zwischen dem Sockel und dem Bauelement anzusetzen, um dieses vorsichtig und gleichmäßig aus dem Sockel herauszuhebeln.

Um die Beschädigung der Anschlußstifte beim Einstecken oder Herausziehen der Bauelemente in den bzw. aus dem Sockel zu vermeiden, sind bereits Sockel bekannt, bei denen die Bauelemente ohne Kraftaufwand in die Sockel eingeführt werden können und bei denen die Anschlußstifte erst nach dem Einführen in die Einstecköffnungen zwischen den Kontaktfedern geklemmt werden. Dies erfolgt beispielsweise dadurch, daß der Sockel zwischen einer Bodenplatte und einer Deckplatte eine Zwischenplatte enthält, durch die hindurch sich die Einstecköffnungen und damit auch die Kontaktfedern erstrecken, die jedoch gegenüber der Bodenplatte und der Deckplatte parallel zu diesen verschoben werden kann, um so die Kontaktfedern gegen die Anschlußstifte zu spannen. Das Verschieben der Platte erfolgt durch das Umlegen eines Hebels. Nachteilig an dieser Ausführungsform ist insbesondere, daß für das Umlegen des Hebels Platz benötigt wird, so daß die Sockel nicht in der optimalen dichten Packung auf einer Leiterplatte angeordnet werden können. Bei einer Vielzahl derartiger Bauelemente spielt der Platzbedarf der einzelnen Bauelemente jedoch eine erhebliche Rolle.

Der Erfindung liegt die Aufgabe zugrunde, einen Sockel der eingangs genannten Art anzugeben, der bei geringstem Platzbedarf ein problemloses Einsetzen und Herausnehmen eines Bauelementes in den bzw. aus dem Sockel ohne die Hilfe von Werkzeugen und ohne die Gefahr einer Beschädigung der Anschlußstifte des Bauelementes ermöglicht.

Diese Aufgabe wird erfindungsgemäß dadurch gelöst, daß der Auflagekörper durch Tastdruck aus dieser zweiten Stellung wieder entriegelbar ist und daß an der Sockelplatte mindestens ein Klemmorgan zum Zusammenspannen von Kontaktfedern und Anschlußstiften im wesentlichen senkrecht zur Einsteckrichtung verstellbar gelagert und mit dem Auflagekörper derart gekoppelt ist, daß es beim Verriegeln und Entriegeln des Auflagekörpers in seine Klemmstellung bzw. aus dieser in seine Freigabestellung überführt ist.

Der wesentliche Vorteil der erfindungsgemäßen Lösung besteht darin, daß die Anschlußstifte des Bauelementes in die Einstecköffnungen des erfindungsgemäßen Sockels praktisch kraftfrei eingeführt werden können, wobei die Klemmung der Anschlußstifte durch die Kontaktfedern erst dann erfolgt, wenn die Anschlußstifte ihre tiefste Stellung erreicht haben. Diese Klemmung und die Verriegelung des Bauelementes in der Betriebsstellung können durch einfachen Tastdruck auf das Bauelement erreicht werden. Umgekehrt erfolgt das Herausnehmen des Bauelementes in derselben Weise, indem wiederum durch einfachen Tastdruck auf das Bauelement und damit auf den Auflagekörper dieser von der Sockelplatte entriegelt wird, wobei die Klemmung der Anschlußstifte durch die Kontaktfedern gelöst wird, bevor das Bauelement durch den in seine erste Stellung oder Freigabestellung vorgespannten Auflagekörper aus dem Sockel herausgehoben wird und anschließend problemlos abgenommen werden kann. Da die Verriegelung und Entriegelung des Auflagekörpers an der Sockelplatte allein durch eine Bewegung senkrecht zur Leiterplatte erfolgt, können die Bauelemente und Sockel auf einer Leiterplatte in sehr geringem Abstand voneinander angeordnet werden.

Verriegelungsmittel, die durch aufeinander folgende Tastbewegungen in der gleichen Richtung sowohl eine Verriegelung als auch eine Entriegelung ermöglichen, sind im Stand der Technik an sich bekannt. Für den vorliegenden Fall eignet sich insbesondere eine sogenannte Herzkurve, die an einem der Teile (Sockelplatte oder Auflagekörper) angeordnet ist und in die ein mit dem jeweils anderen Teil (Auflagekörper oder Sockelplatte) verbundener Führungsstift eingreift. Durch verschieden hohe Rampen rund um die herzförmig gestaltete Führungskurve wird der Führungsstift gezwungen, die herzförmige Kurve immer nur in einer Richtung zu durchlaufen, wobei er zwei definierte Ruhelagen einnehmen kann, die im vorliegenden Beispiel der sockelplattenfernen und der sockelplattennahen Stellung des Auflagekörpers entsprechen.

Um die Bewegung des Auflagekörpers bzw. des Bauelementes in Richtung auf die Sockelplatte gleichzeitig in eine Klemmbewegung des Klemmorganes umzusetzen, wobei einerseits die Klemmung der Anschlußstifte durch die Kontaktfedern erst dann erfolgen soll, wenn die Anschlußstifte vollständig in die Einstecköffnungen eingeführt sind, und andererseits die Klemmung der Anschlußstifte aufgehoben sein muß, bevor das Bauelement mit Hilfe des Auflagekörpers angehoben wird, wird erfindungsgemäß vorgeschlagen, daß das Klemmorgan und der Auflagekörper durch mindestens ein Spannelement miteinander gekoppelt sind. Dieses umfaßt erfindungsgemäß zwei Teile, von denen das erste mit dem Klemmorgan und das zweite mit dem Auflagekörper jeweils um eine zur Verstellrichtung von Auflagekörper und Klemmorgan senkrechte Schwenkachse schwenkbar verbunden ist und die beide im Sinne einer Veränderung ihres gegenseitigen Schwenkachsenabstandes beweglich aneinander geführt sind, wobei eine Rasteinrichtung vorgesehen ist, welche die Teile des Spannelementes während des Verstellens des Auflagekörpers in seine zweite Stellung gegenüber einer Verminderung ihres gegenseitigen Schwenkachsenabstandes arretiert und die beim Entriegeln des Auflagekörpers lösbar ist. Beim Einführen der Anschlußstifte in die Einstecköffnungen verhindert die Rasteinrichtung eine Verkürzung des zwischen dem Auflagekörper und dem Klemmorgan auf Druck belasteten Spannelementes, so daß die Kontaktfedern und die Anschlußstifte gegeneinander gespannt werden. Beim Entriegeln des Auflagekörpers wird dagegen die Rasteinrichtung gelöst, so daß sich die beiden Teile des Spannelementes unter der Wirkung der sich entspannenden Kontaktfeder frei gegeneinander bewegen können, so daß die Klemmung der Anschlußstifte durch die Kontaktfedern aufgehoben ist, bevor der Auflagekörper das Bauelement mit seinen Anschlußstiften aus den Einstecköffnungen heraushebt.

Vorzugsweise sind die beiden Teile des Spannelementes teleskopartig ineinander geführt, wobei an einem der Teile mindestens eine federnd auslenkbare Rastklinke angeordnet ist, die zum Eingriff mit dem anderen Teil bestimmt und beim Entriegeln des Auflagekörpers durch einen Auslöseanschlag aus der Eingriffsstellung auslenkbar ist. Der Auslöseanschlag ist dabei zweckmäßigerweise an dem Klemmorgan ausgebildet. Diese Ausführungsform ermöglicht eine besonders einfache Herstellung für den Fall, daß bei Anordnung der Einstecköffnungen in mindestens einer Reihe das Klemmorgan von einer in der Sockelplatte verschiebbar geführten Klemmleiste gebildet ist, die zur gleichzeitigen Anlage an jeweils einem Federschenkel der Kontaktfedern bestimmt ist. In diesem Falle umfassen die teleskopisch ineinander greifenden Teile des Spannelementes zweckmäßigerweise ein sich mindestens annähernd über die Klemmleistenlänge erstreckendes flaches U-Profil und eine in dieses eingreifende flache Leiste. Die beiden Teile sind jeweils über einen Steg mit einem zylindrischen Gelenkwulst versehen, mit dem sie jeweils in einer komplementären Gelenkpfanne in der Klemmleiste bzw. dem Auflagekörper gelagert sind. Diese Konstruktion ist für beliebig lange Reihen von Einstecköffnungen bzw. Anschlußstiften geeignet.

Je nach Anzahl der Anschlußstifte bzw. Einstecköffnungen in einer Reihe kann eine geeignete Anzahl von Rastklinken in einem der U-Schenkel des U-Profils vorgesehen sein, wobei in dem anderen U-Schenkel dann gegenüber den Rastklinken Aussparungen vorgesehen sind, durch die jeweils ein Auslöseanschlag hindurchtreten kann, wenn der Auflagekörper an der Sockelplatte entriegelt wird.

Um durch einen Blick auf die Leiterplatte sofort feststellen zu können, ob das Bauelement ordnungsgemäß in dem Sockel sitzt und die Anschlußstifte mit den Kontaktfedern in einer einen einwandfreien elektrischen Kontakt sicherstellenden Weise gegeneinander gespannt sind, ist es zweckmäßig, wenn eine Anzeigeeinrichtung zur Anzeige der Stellung des Klemmorganes vorgesehen ist. Diese Anzeigeeinrichtung kann in einfacher Weise derart ausgebildet sein, daß mindestens ein zur Einsteckseite der Sockelplatte hin offenes Fenster in der Sockelplatte vorgesehen ist, durch das hindurch ein Anzeigeelement sichtbar ist, welches die Stellung des Klemmorgans relativ zu den Kontaktfedern angibt.

Um den Auflagekörper zu entriegeln und beispielsweise den Führungsstift aus der definierten Ruhelage der Herzkurve auszulenken, muß das Bauelement zusammen mit dem Auflagekörper und den geklemmten Anschlußstiften um eine geringe Strecke in Richtung auf die Sockelplatte bewegt werden. Damit dabei die Anschlußstifte nicht verbogen werden können, ist es zweckmäßig, wenn die Kontaktfedern eine diese Bewegung des Bauelementes aufnehmende Federstrecke umfassen. Zweckmäßigerweise weisen die Kontaktfedern hierzu jeweils einen U-förmig gekrümmten Aufnahmeabschnitt für den Anschlußstift und einen die Sockelplatte durchsetzenden Fußabschnitt auf, der mit dem Aufnahmeabschnitt durch einen um eine senkrecht zur Einsteckrichtung gerichtete Achse gekrümmten Federbügel verbunden ist. Diese Federbügel können eine Bewegung der Anschlußstifte bzw. des mit ihnen starr verbundenen Elementes auch dann aufnehmen, wenn die Anschlußstifte zwischen den Schenkeln des U-förmig gekrümmten Aufnahmeabschnittes fest eingeklemmt sind und sich relativ zu diesen Schenkeln des Aufnahmeabschnittes nicht bewegen können.

Weitere Merkmale und Vorteile der Erfindung ergeben sich aus den restlichen Unteransprüchen und der folgenden Beschreibung, welche in Verbindung mit den beigefügten Zeichnungen die Erfindung anhand eines Ausführungsbeispieles erläutert. Es zeigen :

Fig. 1 eine schematische Draufsicht auf einen erfindungsgemäßen Sockel,

Fig. 2 einen schematischen Teilschnitt durch den Sockel längs Linie II-II in Fig. 1 mit dem Auflagekörper in seiner entriegelten Stellung,

Fig. 3 einen der Fig. 2 entsprechenden Schnitt mit dem Auflagekörper in dessen verriegelter Stellung,

Fig. 4 einen vergrößerten Teilschnitt durch das Spannelement in einer den Fig. 2 und 3 entsprechenden Schnittebene,

Fig. 5 eine perspektivische Darstellung der Teile des Spannelementes und

Fig. 6 eine schematische Draufsicht auf die zur Verriegelung und Entriegelung des Auflagekörpers an der Sockelplatte dienenden Herzkurve.

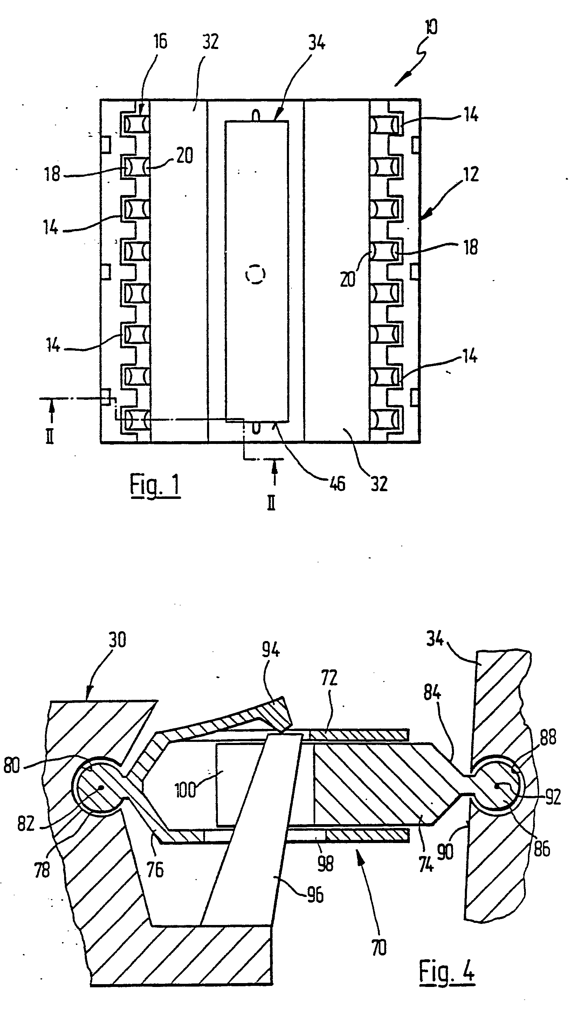

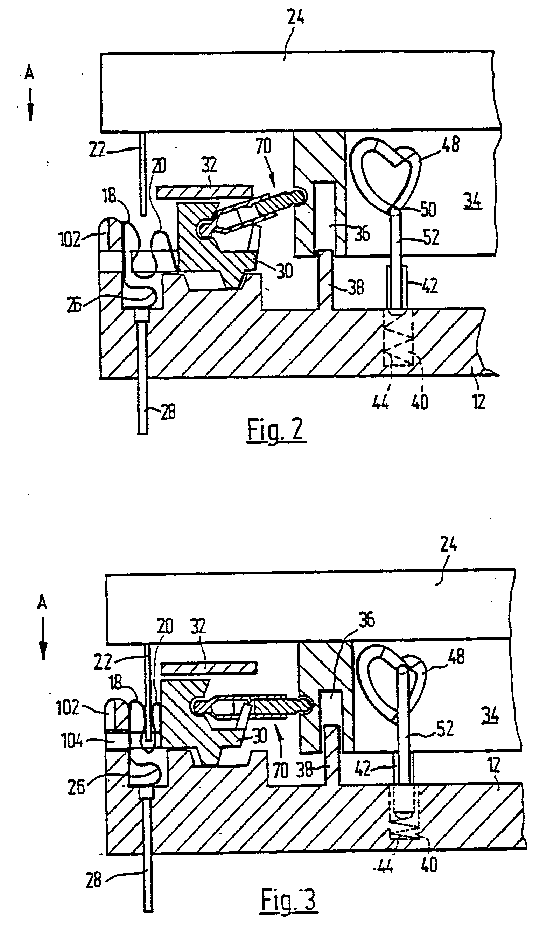

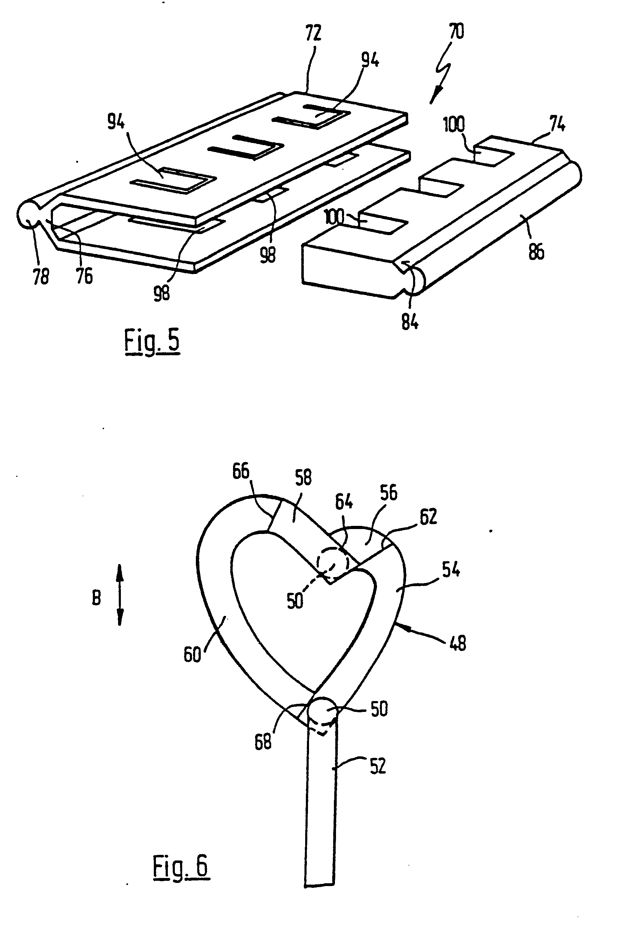

Der in Fig. 1 dargestellte allgemein mit 10 bezeichnete Sockel umfaßt eine rechteckige Sockelplatte 12 mit zwei Reihen von Einstecköffnungen 14, die sich entlang zweier einander gegenüber liegender Rechteckseiten erstrecken. In jeder Einstecköffnung 14 ist eine Kontaktfeder 16 angeordnet, die gemäß den Fig. 2 und 3 einen U-förmig gekrümmten Aufnahmeabschnitt mit zwei Federschenkeln 18 und 20 aufweist, zwischen die jeweils ein Anschlußstift 22 eines elektronischen Bauelementes 24 einführbar ist, wie dies in den Fig. 2 und 3 zu erkennen ist. Der Federschenkel 18 ist über einen gekrümmten Federbügel 26 mit einem Fuß 28 der Kontaktfeder verbunden, der die Sockelplatte durchsetzt und aus dieser nach unten herausragt. Mit den Füssen 28 kann die Sockelplatte auf einer nicht dargestellten Leiterplatte aufgelötet werden. Die Krümmungsachse des Federbügels 26 ist senkrecht zu der durch den Pfeil A in Fig. 2 angegebenen Einsteckrichtung der Anschlußstifte 22 in die zugehörigen Einstecköffnungen 14 gerichtet. Die Funktion dieses Federbügels 26 wird weiter unten noch näher erläutert.

Die Federbügel 18 und 20 jeder Kontaktfeder sind so gebogen, daß sie im unbelasteten Zustand einen Abstand voneinander aufweisen und ein reibungsfreies Einführen des Anschlußstiftes 22 in den Aufnahmeabschnitt der Kontaktfeder 16 ermöglichen (siehe Fig. 2). Die Kontaktgabe zwischen der Kontaktfeder und den Anschlußstiften 22 erfolgt erst dadurch, daß die Federschenkel 16 und 20 mittels einer Klemmleiste 30 gegeneinander gespannt werden, die in der Sockelplatte 12 unter einer Abdeckung 32 senkrecht zur Einsteckrichtung A und senkrecht zu der Reihe von Einstecköffnungen 14 verschiebbar gelagert ist. Der Mechanismus zur Betätigung der Klemmleiste 30 und zum Festhalten derselben in ihrer Klemmstellung wird nun im folgenden erläutert.

Zwischen den beiden Abdeckungen 32 ist auf der Oberseite der Sockelplatte 12 ein rechteckiger Auflagekörper 34 parallel zur Einsteckrichtung A verstellbar gelagert. Der Auflagekörper 34 weist auf seiner der Sockelplatte 12 zugekehrten Seite Nuten 36 auf, die zur Aufnahme von Führungsrippen 38 an der Oberseite der Sockelplatte 12 dienen und zusammen mit diesen eine verkantungsfreie Führung des Auflagekörpers 34 bei seiner Bewegung relativ zur Sockelplatte 12 gewährleisten. In der Sockelplatte 12 unterhalb des Auflagekörpers 34 ist eine Bohrung 40 ausgebildet, in die ein mit dem Auflagekörper 34 verbundener Zapfen 42 eingreift. Zwischen dem Boden der Bohrung 40 und dem ihm zugekehrten Ende des Zapfens 42 ist eine Schraubendruckfeder 44 angeordnet, welche den Auflagekörper 34 nach oben, das heißt in Richtung auf eine Vergrößerung des Abstandes zwischen Auflagekörper 34 und Sockelplatte 12 vorspannt.

An den kurzen Seitenflächen 46 des rechteckigen Auflagekörpers 34 ist jeweils eine herzförmige Steuerkurve 48 ausgebildet, in die das hakenförmige Ende 50 eines mit der Sockelplatte 12 fest verbundenen drahtförmigen Federbügels 52 eingreift (siehe insbesondere Fig. 6). Die herzförmige Steuerkurve umfaßt vier rampenförmige Abschnitte 54, 56, 58 und 60, die jeweils durch eine Sprungkante 62, 64, 66 bzw. 68 voneinander getrennt sind, wobei beim Durchlaufen der Steuerkurve 48 im Gegenuhrzeigersinn an der jeweiligen Sprungkante der gerade durchlaufene Kurvenabschnitt höher ist als der folgende Kurvenabschnitt, so daß das hakenförmige Ende 50 des Federbügels 52 unter der Federvorspannung desselben an der Sprungkante jeweils auf den nächstfolgenden Kurvenabschnitt springt, jedoch nicht mehr zurück kann. Diese Steuerkurve weist zwei stabile Ruhelagen für den Federbügel 52 auf, wobei der Übergang aus einer Ruhelage in die andere jeweils allein durch eine Relativbewegung der Herzkurve und des Federbügels 52 in Richtung des Doppelpfeiles B erfolgt. Im vorliegenden Falle entspricht die in der Fig. 6 dargestellte Stellung des Federbügels 52 in der Steuerkurve 48 der sockelplattenfernen Stellung des Auflagekörpers 34 relativ zur Sockelplatte 12 (siehe Fig. 2). Drückt man in Einsteckrichtung A auf den Auflagekörper 34, so durchläuft das hakenförmige Ende 50 des Federbügels 52 zwangsweise den Kurvenabschnitt 54 der Steuerkurve 48, da es an der Sprungkante 68 nicht auf den an dieser Stelle höheren Kurvenabschnitt 60 springen kann. Bei weiterer Annäherung des Auflagekörpers 34 an die Sockelplatte 12 erreicht der Federbügel 52 mit seinem hakenförmigen Ende 50 das Ende des Kurvenabschnittes 54, springt über die Kante 62 und stößt am oberen Ende des Kurvenabschnittes 56 an der Außenwand der Steuerkurve 48 an. Damit hat der Auflagekörper 34 seine der Sockelplatte 12 nächste Stellung während dieses Bewegungsabschnittes erreicht. Beim Loslassen des Auflagekörpers 34 wird dieser unter der Wirkung der Schraubendruckfeder 44 von der Sockelplatte 12 weg gedrückt, wobei das hakenförmige Ende 50 des Federbügels 52 entlang der Sprungkante 62 unter Überspringen der Sprungkante 64 in seine in der Fig. 6 durch gestrichelte Linien angedeutete zweite stabile Ruhelage gleitet. Dadurch wird der Auflagekörper 34 in seiner sockelplattennahen zweiten Stellung festgehalten. Aus dieser zweiten stabilen Ruhelage läßt sich der Federbügel 52 dadurch auslenken, daß man wiederum den Auflagekörper 34 in Richtung auf die Sockelplatte 12 bewegt, wobei das hakenförmige Ende 50 des Federbügels 52 zwangsweise entlang der Sprungkante 64 in Richtung auf die Sprungkante 66 bewegt wird, diese überspringt und den höchsten Punkt des Kurvenabschnittes 60 erreicht. Nach Loslassen des Auflagekörpers 34 kehrt dieser in seine sockelplattenferne Ausgangsstellung zurück, wobei das hakenförmige Ende 50 des Federbügels 52 den Bahnabschnitt 60 durchläuft, die Sprungkante 68 überspringt und wieder seine in der Fig. 6 dargestellte untere Ausgangslage einnimmt. Auf die Unsymmetrie der Steuerkurve 48 und die Tatsache, daß der Auflagekörper 34 zum Entriegeln aus der sockelplattennahen Stellung näher an die Sockelplatte 12 angedrückt werden muß, wird weiter unten noch näher eingegangen.

Die Klemmleiste 30 ist mit dem Auflagekörper 34 durch ein allgemein mit 70 bezeichnetes Spannelement derart gekoppelt, daß die Klemmleiste 30 in der sockelplattenfernen Stellung des Auflagekörpers 34 die Federschenkel 18, 20 der Kontaktfedern 16 freigibt und in der sockelplattennahen Endstellung des Auflagekörpers 34 die Federschenkel 18, 20 der Kontaktfedern 16 gegeneinander spannt (Fig. 2 und 3). Aufbau und Funktion des Spannelementes 70 werden nun anhand der Fig. 4 und 5 näher erläutert. Das Spannelement umfaßt ein erstes Teil in Form eines U-Profils 72 und ein zweites Teil in Form einer in das U-Profil einschiebbaren Leiste 74. An der Außenseite des U-Quersteges 76 des U-Profiles 72 ist parallel zur Längsrichtung des U-Profils 72 ein im Querschnitt teilzylindrischer Steg 78 ausgebildet, der in eine komplementäre Längsnut 80 der Klemmleiste 30 eingreift, so daß das U-Profil 72 mit der Klemmleiste 30 um eine zur Längsrichtung der Klemmleiste 30 parallele Schwenkachse 82 schwenkbar verbunden ist. In der gleichen Weise ist entlang der dem U-Profil 72 abgewandten Längsseite 84 der Leiste 74 ein Gelenkwulst 86 ausgebildet, der in eine komplementäre Rinne 88 an der der Klemmleiste 30 zugewandten Seitenfläche 90 des Auflagekörpers 34 eingreift, so daß die Leiste 74 um eine zur Schwenkachse 82 parallele Schwenkachse 92 mit dem Auflagekörper 34 gelenkig verbunden ist. Die beiden Teile 72 und 74 bilden somit zusammen einen einerseits mit der Klemmleiste 30 und andererseits mit dem Auflagekörper 34 gelenkig verbundenen Doppellenker, der durch die teleskopische Führung der beiden Teile 72 und 74 ineinander in seiner Länge veränderbar ist.

Diese Längenänderung des Spannelementes 70 wird durch Rastklinken 94 begrenzt, die in einem der U-Schenkel des U-Profils 72 ausgebildet sind und mit ihren Rastnasen in den Innenraum des U-Profils 72 hineinragen. Beim Einschieben der Leiste 74 in das U-Profil 72 schlägt die Leiste an diesen Rastklinken 94 an. Bei der Bewegung des Auflagekörpers 34 in Richtung auf die Sockelplatte 12 kann somit über das Spannelement 70 ein Druck auf die Klemmleiste 30 übertragen werden, um diese aus ihrer in Fig. 2 dargestellten Freigabestellung in die in der Fig. 3 dargestellte Klemmstellung zu verschieben. Bei dieser Bewegung verhält sich das Spannelement 70 als starres Teil. Liegt auf dem Auflagekörper 34 ein Bauelement 24 auf, das mit seinen Anschlußstiften 22 zwischen die Federschenkel 18 und 20 der Kontaktfedern 16 eingreift, so werden die Anschlußstifte 22 zwischen den Federschenkeln 18 und 20 eingeklemmt, wenn der Auflagekörper 34 seine sockelplattennahe Endstellung erreicht. Da zum Einführen des hakenförmigen Endes 50 des Federbügels 52 in die obere Ruhelage der Steuerkurve 48 (Fig. 6) ein gewisser Überhub erforderlich ist, muß das Bauelement 24 zusammen mit dem Auflagekörper 34 noch in Richtung auf die Sockelplatte 12 bewegt werden, während die Anschlußstifte 22 bereits zwischen den Federschenkeln 18 und 20 der Kontaktfedern 16 eingeklemmt sind. Um dabei eine Beschädigung der Anschlußstifte 22 während dieses Überhubes zu vermeiden, können sich die Federschenkel 18 und 20 zusammen mit den Anschlußstiften 22 aufgrund der durch den Federbügel 26 der Kontaktfeder 16 bestehenden Elastizität in Einsteckrichtung A mit bewegen.

Beim Entriegeln des Auflagekörpers 34 zum Herausnehmen des Bauelementes 24 aus dem Sockel 10 soll die Klemmung der Anschlußstifte 22 aufgehoben sein, bevor sich der Auflagekörper 34 aus einer sockelplattennahen Ruhestellung wesentlich von der Sockelplatte 12 entfernt. Hierzu ist jeder Rastklinke 94 des U-Profiles 72 ein Entriegelungsfinger 96 zugeordnet, der an der Klemmleiste 30 angeordnet ist und jeweils durch eine Aussparung 98 in dem den Rastklinken 94 gegenüber liegenden U-Schenkel des U-Profiles 72 in dieses eingreifen kann. Wird beim Entriegeln des Auflagekörpers 34 aus einer sockelplattennahen Stellung der Auflagekörper 34 aufgrund des erforderlichen Überhubes zunächst in Richtung auf die Sockelplatte 12 bewegt, so dringen die Entriegelungsfinger 96 durch die Durchbrechungen 98 in das U-Profil 72 ein und drücken die Rastklinken 94 nach außen. Dadurch wird die Sperre für das Eindringen der Leiste 74 in das U-Profil 72 aufgehoben, so daß die Federschenkel 18 und 20 der Kontaktfedern 14 die Klemmleiste 30 in Richtung auf den Auflagekörper 34 verschieben und damit die Anschlußstifte 22 des Bauelementes 24 freigeben können, noch bevor das Bauelement 24 durch den unter der Wirkung der Feder 44 in seine sockelplattenferne Endstellung zurückkehrenden Aufhlagekörper 34 aus dem Sockel 10 herausgehoben wird. Da beim Einschieben der Leiste 74 über die durch die Rastklinken 94 bestimmte Endstellung hinaus die Entriegelungsfinger 96 im Wege wären, sind in der Leiste 74 schlitzförmige Aussparungen 100 vorgesehen, in welche die Entriegelungsfinger 96 hineingleiten können. Die Breite der Schlitze 100 und der Entriegelungsfinger 96 ist dabei geringer als die Breite der Rastklinken 94, so daß deren Sperrfunktion trotzdem gewährleistet ist.

Aus der vorstehenden Beschreibung ergibt sich zwangsläufig, daß der Überhub der Steuerkurve 48 beim Entriegeln größer sein muß als der Überhub beim Verriegeln, da sonst bereits beim Verriegeln die Entriegelungsfinger 96 gegen die Rastklinken 94 stoßen und damit die Klemmfunktion der Klemmleiste aufheben würden. Daraus folgt die Unsymmetrie der in der Fig. 6 dargestellten herzförmigen Steuerkurve 48.

Um die Stellung der Klemmleiste leicht überprüfen zu können, sind in der Sockelplatte 12 nahe den Einstecköffnungen 14 Fenster 102 ausgebildet, durch die hindurch mit der Klemmleiste 30 verbundene Fortsätze 104 sichtbar werden, wenn sich die Klemmleiste 30 in ihrer Klemmstellung gemäß Fig. 3 befindet. In der Freigabestellung der Klemmleiste 30 gemäß Fig. 2 verschwinden die Fortsätze 104 aus den Fenstern. Zum leichteren Erkennen der Fortsätze 104 können diese aus einem gegenüber der Sockelplatte 12 andersfarbigen Material hergestellt sein.

Nachzutragen ist noch, daß der erfindungsgemäße Sockel auch nachträglich auf vorhandenen Leiterplatten angeordnet werden kann, da er nicht mehr Grundfläche benötigt als das Bauelement selbst.

## Patentansprüche

1. Sockel zur Halterung eines eine Vielzahl von Anschlußstiften aufweisenden elektronischen Bauelementes auf einer Leiterplatte, umfassend eine Sockelplatte mit einer Vielzahl von Einstecköffnungen, in denen jeweils eine Kontaktfeder zum Kontaktieren eines in die Einstecköffnung eingeführten Anschlußstiftes des Bauelementes angeordnet ist, wobei ein Auflagekörper (34) für das Bauelement (24) auf der Sockelplatte (12) angeordnet ist, der parallel zur Einsteckrichtung (A) der Anschlußstifte (22) relativ zur Sockelplatte (12) aus einer sockelplattenfernen ersten Stellung gegen Federkraft in eine sockelplattennahe, dem vollständigen Einführen der Anschlußstifte (22) in die Einstecköffnungen (14) entsprechende zweite Stellung verstellbar ist, wobei der Auflagekörper (34) jeweils durch Tastdruck in Richtung auf die Sockelplatte (12) in seiner zweiten Stellung verriegelbar ist, dadurch gekennzeichnet, daß der Auflagekörper durch Tastdruck aus dieser zweiten Stellung wieder entriegelbar ist und daß an der Sockelplatte (12) mindestens ein Klemmorgan (30) zum Zusammenspannen von Kontaktfedern (16) und Anschlußstiften (22) im wesentlichen senkrecht zur Einsteckrichtung (A) verstellbar gelagert und mit dem Auflagekörper (34) derart gekoppelt ist, daß es beim Verriegeln und Entriegeln des Auflagekörpers (34) in seine Klemmstellung bzw. aus dieser in seine Freigabestellung überführt ist.

2. Sockel nach Anspruch 1, dadurch gekennzeichnet, daß die Mittel zur Verriegelung des Auflagekörpers (34) an der Sockelplatte (12) eine herzförmige Steuerkurve (48) an einem der Teile (Sockelplatte 12 oder Auflagekörper 34) und einen in die Steuerkurve (48) eingreifenden und mit dem jeweils anderen Teil (Auflagekörper 34 oder Sockelplatte 12) verbundenen Führungsstift (52) umfassen.

3. Sockel nach Anspruch 1 oder 2, dadurch gekennzeichnet, daß das Klemmorgan (30) und der Auflagekörper (34) durch mindestens ein Spannelement (70) miteinander gekoppelt sind, umfassend zwei Teile (72, 74), von denen das erste (72) mit dem Klemmorgan (30) und das zweite (74) mit dem Auflagekörper (34) jeweils um eine zur Verstellrichtung von Auflagekörper (34) und Klemmorgan (30) senkrechte Schwenkachse (82, 92) schwenkbar verbunden ist und die beide im Sinne einer Veränderung ihres gegenseitigen Schwenkachsenabstandes beweglich aneinander geführt sind, und daß eine Rasteinrichtung (94) vorgesehen ist, welche die Teile (72, 74) des Spannelementes (70) während des Verstellens des Auflagekörpers (34) in seine zweite Stellung gegenüber einer Verminderung ihres gegenseitigen Schwenkachsenabstandes arretiert und die beim Entriegeln des Auflagekörpers (34) lösbar ist.

4. Sockel nach Anspruch 3, dadurch gekennzeichnet, daß die beiden Teile (72, 74) des Spannelementes (70) teleskopartig ineinander geführt sind und daß an einem der Teile mindestens eine federnd auslenkbare Rastklinke (94) angeordnet ist, die zum Eingriff mit dem anderen Teil bestimmt und beim Entriegeln des Auflagekörpers (34) durch einen Auslöseanschlag (96) aus der Eingriffsstellung auslenkbar ist.

5. Sockel nach Anspruch 4, dadurch gekennzeichnet, daß der Auslöseanschlag (96) an dem Klemmorgan (30) ausgebildet ist.

6. Sockel nach einem der Ansprüche 1 bis 5, dadurch gekennzeichnet, daß bei Anordnung der Einstecköffnungen (14) in mindestens einer Reihe das Klemmorgan (30) von einer in der Sockelplatte (12) verschiebbar geführten Klemmleiste gebildet ist, die zur Anlage an einem Federschenkel (20) der jeweiligen Kontaktfeder (16) bestimmt ist.

7. Sockel nach Anspruch 4 und 6, dadurch gekennzeichnet, daß die teleskopisch ineinander greifenden Teile des Spannelementes (70) von einem sich mindestens annähernd über die Klemmleistenlänge erstreckenden flachen U-Profil (72) und einer in dieses eingreifenden flachen Leiste (74) gebildet sind, die jeweils über einen Steg mit einem zylindrischen Gelenkwulst (78, 86) versehen sind, mit dem sie jeweils in einer komplementäre Gelenkpfanne (80, 88) in der Klemmleiste (30) bzw. dem Auflagekörper (34) gelagert sind.

8. Sockel nach Anspruch 7, dadurch gekennzeichnet, daß in dem einen U-Schenkel des U-Profils (72) mehrere nach innen weisende Rastklinken (94) und in dem anderen U-Schenkel gegenüber den Rastklinken (94) Aussparungen (98) zum Durchtritt jeweils eines Auslöseanschlages (96) ausgebildet sind.

9. Sockel nach einem der Ansprüche 1 bis 8, dadurch gekennzeichnet, daß eine Anzeigeeinrichtung zur Anzeige der Stellung des Klemmorgans vorgesehen ist.

10. Sockel nach Anspruch 9, dadurch gekennzeichnet, daß die Anzeigeeinrichtung mindestens ein zur Einsteckseite hin offenes Fenster (102) in der Sockelplatte (12) und ein in Abhängigkeit der Stellung des Klemmorgans (30) relativ zum Fenster (102) verstellbares Anzeigeelement (104) umfaßt.

11. Sockel nach Anspruch 10, dadurch gekennzeichnet, daß das Anzeigeelement (104) von einem gegenüber der Sockelplatte (12) unterschiedlich gefärbten Abschnitt des Klemmorgans (30) gebildet ist.

12. Sockel nach einem der Ansprüche 1 bis 11, dadurch gekennzeichnet, daß die Kontaktfedern (16) jeweils einen U-förmig gekrümmten Aufnahmeabschnitt für den Anschlußstift (22) und einen die Sockelplatte (12) durchsetzenden Fußabschnitt (28) aufweisen, der mit dem Aufnahmeabschnitt durch einen um eine senkrecht zur Einsteckrichtung (A) gerichtete Achse gekrümmten Federbügel (26) verbunden ist.

## Claims

1. A base for mounting a multicontact-pin electronic component on a printed circuit board, the base comprising a baseboard formed with a number of plug-in apertures each having disposed in it a contact spring for contacting a connection pin of the component upon such pin being introduced into the aperture, a support member (34) for the component (24) being disposed on the baseboard (12) and being movable parallel to the plug-in direction (A) of the connecting pins (22) relatively to the base board (12) and against spring force from a first position remote from the baseboard to a second position near the same and corresponding to complete introduction of the connecting pins (22) into the apertures (14), the support member (34) being lockable in its second position by being pressed towards the baseboard (12), characterised in that the support member is unlockable from this second position by pressure and at least one clamping element (30) for clamping together the contact springs (16) and connecting pins (22) is mounted on the base board (12) for movement substantially perpendicular to the plug-in direction (A) and is so coupled with the support member (34) as to change over into its clamping position upon locking of the support member (34) and to change over into its release position upon unlocking of the support member (34).

2. A base according to claim 1, characterised in that the means for locking the support member (34) to the baseboard (12) comprise : a cardioid cam (48) on one of the parts (baseboard 12 or support member 34) and a guide pin (52) which engages in the cam (48) and which is connected to the other part (support member 34 or baseboard 12).

3. A base according to claim 1 or 2, characterised in that the clamping element (30) and the support member (34) are interconnected by at least one clamping element (70) comprising two parts (72, 74), the first part (72) being pivotally connected to the clamping element and the second part (74) being pivotally connected to the support member (34), the pivoting being in each case around a pivot (82, 92 respectively) which is perpendicular to the direction of movement of the support member (34) and clamping element (30), both the parts (72, 74) being movably guided on one another in the sense of a variation of their between-pivots distance, and detent means (94) are provided which lock the parts (72, 74) of the clamping element (70) during the movement of the support member (34) into its second position against a reduction in their between-axes distance and which are releasable upon unlocking of the support member (34).

4. A base according to claim 3, characterised in that the two parts (72, 74) of the clamping element (70) are guided telescopically one in another and at least one resiliently deflectable detent pawl (94) is disposed on one of the parts, is adapted for engagement with the other part and is deflectable by an abutment (96) from the engaged position upon unlocking of the support member (34).

5. A base according to claim 4, characterised in that the abutment (96) is devised on the clamping element (30).

6. A base according to any of claims 1-5, characterised in that when the plug-in apertures (14) are disposed in at least one row the clamping element (30) takes the form of a clamping strip displaceably guided in the baseboard (12) and adapted to abut a spring arm (20) of the particular contact spring (16) concerned.

7. A base according to claims 4 and 6, characterised in that the telescopically engaging parts of the clamping elements (70) are embodied by a shallow channel-section member (72) extending at least substantially over clamping strip length and by a flat strip (74) engaging in the channel-section member, the parts (72, 74) each having by way of a web a respective cylindrical pivot bead (78, 86) by way of which they are mounted in a companion socket (80, 88 respectively) in the clamping strip (30) and support member (34 respectively).

8. A base according to claim 7, characterised in that one arm of the channel-section member (72) has a number of inwardly extending pawls (94) and the other U-arm is formed opposite the pawls (94) with recesses (98) through each of which a release abutment (96) can extend.

9. A base according to any of claims 1-8, characterised in that means for indicating the position of the clamping element are provided.

10. A base according to claim 9, characterised in that the indicating means comprise : at least one window (102) in the baseboard (12), the window being open towards the plug-in side ; and an indicating element (104) which is movable relatively to the window (102) in dependence upon the position of the clamping element (30).

11. A base according to claim 10, characterised in that the indicating element (104) is embodied by a clamping element part coloured differently from the baseboard (12).

12. A base according to any of claims 1-11, characterised in that each contact spring (16) has a U-shaped part to receive the connecting pin (22) and a leg part (28) which extends through the baseboard (12) and which is connected to the pin-receiving part by a curved bowed spring (26) disposed around an axis which extends perpendicularly to the plug-in direction (A).

**Revendications**

1. Socle pour la fixation sur une plaquette de circuits imprimés d'un composant électronique présentant une pluralité de broches de sortie, comprenant une plaque de socle avec une pluralité d'ouvertures d'enfichage dans chacune desquelles est disposé un ressort de contact pour assurer le contact avec une broche de sortie du composant introduite dans l'ouverture d'enfichage, un support (34) pour le composant (24) étant disposé sur la plaque de socle (12) et pouvant être déplacé parallèlement au sens d'enfichage (A) des broches de sortie (22) relativement à la plaque de socle (12), contre la force d'un ressort, à partir d'une première position éloignée de la plaque de socle jusqu'à une deuxième position proche de la plaque de socle correspondante à l'introduction complète des broches de sortie (22) dans les ouvertures d'enfichage (14), le support (34) pouvant être verrouillé à sa deuxième position par une pression sur une touche en direction de la plaque de socle (12), caractérisé en ce que le support (34) peut, par une pression sur la touche, être à nouveau déverrouillé à cette deuxième position et que, sur la plaque de socle (12) est monté déplaçable essentiellement perpendiculairement à la direction d'enfichage (A) au moins un organe de serrage (30) pour serrer ensemble les ressorts de contact (16) et les broches de sortie (22) et cet organe est accouplé avec le support (34) de telle façon que, pendant le verrouillage et le déverrouillage du support (34), il est mis respectivement à sa position de serrage et, à partir de celle-ci, à sa position de libération.

2. Socle selon la revendication 1, caractérisé en ce que les moyens pour le verrouillage du support (34) sur la plaque de socle (12) comprennent une rainure de commande (48) en forme de coeur sur l'une des pièces (plaque de socle 12 ou support 34) et une goupille de guidage (52) s'engageant dans la rainure de guidage (48) et réunie à l'autre pièce (support 34 ou plaque de socle 12).

3. Socle selon la revendication 1 ou 2, caractérisé en ce que l'organe de serrage (30) et le support (34) sont accouplés l'un avec l'autre par au moins un élément tendeur (70) comprenant deux parties (72, 74) dont la première (72) et la deuxième (74) sont montées pivotantes respectivement sur l'organe de serrage (30) et sur le support (34) chacune au moyen d'un axe de pivotement (82, 92) perpendiculaire au sens de déplacement du support (34) et de l'organe de serrage (30) et les deux parties sont guidées l'une sur l'autre pour se mouvoir dans le sens d'une modification de la distance entre leurs axes de pivotement respectifs, et il est prévu un dispositif d'encliquetage (94) qui arrête les parties (72, 74) pendant le déplacement du support (34) vers sa deuxième position contre une diminution de la distance entre leurs axes de pivotement respectifs et qui peut être libéré au moment du déverrouillage du support (34).

4. Socle selon la revendication 3, caractérisé en ce que les deux parties (72, 74) de l'élément tendeur (70) sont guidées télescopiquement l'une dans l'autre et qu'il est prévu sur une des parties au moins un cliquet d'arrêt (94) repoussable élastiquement qui est destiné à s'engager avec l'autre partie et qui, au moment du déverrouillage du support (34), est repoussé hors de sa position d'engagement par une butée de dégagement (96).

5. Socle selon la revendication 4, caractérisé en ce que la butée de dégagement (96) est disposée sur l'organe de serrage (30).

6. Socle selon une quelconque des revendications 1 à 5, caractérisé en ce que, avec la disposition des ouvertures d'enfichage (14) en au moins une rangée, l'organe de serrage (30) est conformé comme une bande de serrage guidée en coulissement dans la plaque de socle (12) et conçu pour son application contre une branche (20) du ressort de contact (16) correspondant.

7. Socle selon les revendications 4 et 6, caractérisé en ce que les parties de l'élément tendeur (70) guidées télescopiquement l'une dans l'autre sont composées d'un profilé en U plat s'étendant au moins approximativement sur la longueur de la bande de serrage et d'une réglette (74) plate s'engageant dans ce profil en U, qui sont prévus respectivement au moyen d'une barrette d'une languette cylindrique d'articulation (78, 86) par laquelle ils sont articulés dans une cavité complémentaire d'articulation (80, 88) de la bande de serrage (30) et du support (34).

8. Socle selon la revendication 7, caractérisé en ce que, dans l'une des branches du profilé en U (72) sont prévus plusieurs cliquets d'arrêt (94) tournés vers l'intérieur et, dans l'autre branche du profilé en U, en face des cliquets d'arrêt (94) des évidements (98) pour le passage à travers chacun d'eux d'une butée de dégagement (96).

9. Socle selon une quelconque des revendications 1 à 8, caractérisé en ce qu'il est prévu un dispositif indicateur pour indiquer la position de l'organe de serrage.

10. Socle selon la revendication 9, caractérisé en ce que le dispositif indicateur comprend au moins une fenêtre (102) ouverte dans la plaque de socle (12) vers le côté d'enfichage et un élément indicateur (104) déplaçable par rapport à la fenêtre (102) en relation avec la position de l'organe de serrage (30).

11. Socle selon la revendication 10, caractérisé en ce que l'élément indicateur (104) est constitué par une partie de l'organe de serrage (30) colorée de manière distinctive par rapport à la plaque de socle (12).

12. Socle selon l'une quelconque des revendications 1 à 11, caractérisé en ce que les ressorts de contact (16) ont chacun un logement incurvé en U de réception de la broche de sortie (22) et un pied (28) traversant la plaque de socle (12) qui est relié au logement par un étrier élastique (26) incurvé autour d'un axe dirigé perpendiculairement à la direction d'enfichage (A).

Fig. 1

Fig. 4

Fig. 2

Fig. 3

Fig. 5

Fig. 6